# EUROPÄISCHE PATENTSCHRIFT

(11) **EP 2 128 534 B1**
(45) Veröffentlichungstag und Bekanntmachung des Hinweises auf die Patenterteilung: **26.10.2011**
(21) Anmeldenummer: 08104192.3
(22) Anmeldetag: 30.05.2008
(51) Int. Cl.: F24F 11/00, F28D 19/04

(54) **Vorrichtung zum Minimieren eines ungewollten Fluidübertritts von einem ersten Sektor zu einem zweiten Sektor sowie Wärmetauschersystem mit einer derartigen Vorrichtung**
Device for minimising an undesired fluid overflow from a first sector to another sector and heat exchange system with such a device
Dispositif de limitation d'un dépassement liquide indésirable d'un premier secteur dans un deuxième secteur, ainsi que système d'échangeur thermique doté d'un tel dispositif

(43) Veröffentlichungstag der Anmeldung: 02.12.2009
(73) Patentinhaber: Amrona AG, 6302 Zug (CH)
(72) Erfinder: Kind, Michael, 12347 Berlin (DE)
(74) Vertreter: Rupprecht, Kay

(56) Entgegenhaltungen:
- EP-A- 1 777 478
- WO-A-96/06314
- WO-A-2007/032668
- DE-A1- 10 327 078

## Beschreibung

Die Erfindung betrifft ein Wärmetauschersystem mit einer Vorrichtung zum Minimieren eines ungewollten Fluidübertritts von einem ersten Sektor zu einem zweiten Sektor, welche mit einer nicht dichten Abtrennung abgetrennt sind, wobei in dem ersten Sektor ein erster Druck und in dem zweiten Sektor ein im Vergleich zum ersten Druck niedrigerer zweiter Druck herrscht, bei welchem die Vorrichtung zum Einsatz kommt, um einen ungewollten Fluidübertritt von dem Sektor des Wärmetauschersystems, der von dem warmen Fluid durchströmt wird, zu dem Sektor des Wärmetauschersystems, der von dem kalten Fluid durchströmt wird, zu minimieren.

Bei der vorliegenden Erfindung wird von einem umschlossenen Raum ausgegangen, dessen Rau111hülle nicht vollständig gas- bzw. fluiddicht ist, so dass grundsätzlich ungewollte Leckagen auftreten. Derartige Leckagen sind insbesondere an Stellen der Raumhülle zu erwarten, bei welchen Bauteile die Raumhülle durchdringen.

Die Luftdichtigkeit eines Gebäudes und im Einzelnen die Luftdichtigkeit eines mit einer Hülle umschlossenen Raumes ist ein wichtiges Kriterium im Hinblick auf die Wärmedämmung im Hinblick auf die Frage, wie Lüftungswärmeverluste gemindert werden können. Die Luftdichtigkeit eines umschlossenen Raumes wird mit einem Differenzdrucktest (Blower-Door-Test) bestimmt. Dabei wird durch einen in eine Raumhülle (meistens Tür oder Fenster) eingelassenen Ventilator innerhalb des umschlossenen Raumes ein konstanter Überdruck und Unterdruck von z.B. 50 Pa erzeugt und gehalten. Die durch Undichtigkeiten der Raumhülle ausströmende Luftmenge muss durch den Ventilator in den umschlossenen Raum hineingedrückt werden und wird gemessen. Der sogenannte n50-Wert gibt an, wie viel mal das Innenraumvolumen des umschlossenen Raumes pro Stunde umgesetzt wird.

Undichtigkeiten in der Raumhülle führen zu einem ungewollten und unkontrollierten Austausch zwischen der Raumatmosphäre und der Außenatmosphäre. Der dabei auftretende Luftaustausch führt dazu, dass kontinuierlich der Raumatmosphäre Außenluft zugeführt und Innenluft als Abluft abgeführt wird.

Der auf Undichtigkeiten der Raumhülle zurückzuführende (ungewollte) Luftaustausch tritt umso stärker in Erscheinung, je höher die Differenz zwischen dem im Inneren des umschlossenen Raumes und dem außerhalb des Raumes herrschenden Druck ist. Dies trifft beispielsweise für einen Reinraum zu, bei welchem das Eindringen von Staub und Schmutz dadurch verhindert wird, dass im Raum permanent ein Überduck gegenüber der Außenatmosphäre herrscht; eine solche Vorrichtung ist bekannt aus WO 96/06 314. Auf diese Art und Weise soll die Partikelkontamination unter bestimmten Werten liegen. Rein- und Reinströme werden für spezielle Fertigungsverfahren, vor allem in der Halbleiterfertigung benötigt, um die Strukturierung integrierter Schaltkreise im Bereich von Bruchteilen eines mikrometer nicht zu stören. Die aufgrund von Undichtigkeiten in der Raumhülle auftretende Leckagen führen bei einem Raum, in welchem gegenüber der Außenatmosphäre ein Überdruck eingestellt wurde, letztendlich dazu, dass das Medium der Raumatmosphäre durch Undichtigkeiten der Raumhülle austritt, und somit der Überdruck abgebaut wird.

Der aufgrund von Undichtigkeiten in der Raumhülle auftretende Fluidübertritt von der Raumatmosphäre zu der Außenatmosphäre spielt aber auch bei Räumen eine Rolle, deren Raumatmosphäre beispielsweise durch Zugabe eines Inertgases einen im Vergleich zur "normalen" Luft reduzierten Sauerstoffanteil aufweist. Ein derartiges Inertisierungsniveau, bei welchem die Raumatmosphäre einen im Vergleich zur "normalen" Luft reduzierten Sauerstoffanteil aufweist, wird oftmals als präventive Brandschutzmaßnahme eingestellt. Aufgrund der Reduktion des Sauerstoffanteils in dem umschlossenen Raum kann das Risiko der Entstehung eines Brandes minimiert werden. Da über Undichtigkeiten in der Raumhülle ein ungewollter Fluidübertritt von der inertisierten Raumatmosphäre zu der Außenatmosphäre auftreten kann, ist im präventive Brandschutz die Dichtigkeit der Raumhülle ein wichtiges Kriterium was die Frage betrifft, wie viel Inertgas pro Zeiteinheit dem umschlossenen Raum nachgeführt werden muss, damit die gewünschte und für einen wirksamen Brandschutz erforderliche Inertisierung permanent gehalten werden kann. Das Problem dabei ist, dass aufgrund der auf Undichtigkeiten der Raumhülle zurückzuführenden Leckageströme bei einem inertisierten Raum eine permanente Zufuhr von Frischluft und somit Sauerstoff in den inertisierten Raum stattfindet, so dass - sofern Inertgas nicht nachgeführt wird - der Sauerstoffgehalt in Raumatmosphäre ansteigt und der gewünschte Brandschutz nicht mehr gegeben ist.

Dieser Effekt ist besonders ausgeprägt, wenn in dem umschlossenen Raum ein im Vergleich zur Außenatmosphäre höherer Druck herrscht.

Aufgrund der geschilderte Problemstellung liegt der Erfindung die Aufgabe zugrunde, eine Vorrichtung anzugeben, mit welcher in einer einfachen und dennoch effektiven Art und Weise ein ungewollter Fluidübertritt von einem ersten Sektor zu einem zweiten Sektor minimiert werden kann, selbst wenn diese beiden Sektoren mit einer nicht gas- bzw. fluiddichten Abtrennung abgetrennt sind und in dem ersten Sektor ein erster Druck und in dem zweiten Sektor ein im Vergleich zum ersten Druck niedrigerer zweiter Druck herrscht.

Zur Lösung dieser Aufgabe wird erfindungsgemäß eine Vorrichtung vorgeschlagen, die an der den ersten Sektor von dem zweiten Sektor abtrennenden Abtrennung eine die Abtrennung überdeckende Zwischenkammer sowie eine Fördereinrichtung aufweist, wobei die Fördereinrichtung ausgelegt ist, in der Zwischenkammer einen Unterdruck gegenüber dem in dem ersten Sektor herrschenden ersten Druck zu erzeugen, wobei der in der Zwischenkammer erzeugte Druck gleich groß wie oder größer als der in dem zweiten Sektor herrschende zweite Druck ist, und wobei die Fördereinrichtung ausgelegt ist, Fluid von der Zwischenkammer in den ersten Sektor zu fördern.

Der Erfindung liegt die Erkenntnis zugrunde, dass der von dem ersten Sektor über die Abtrennung zu dem zweiten Sektor auftretende Leckagestrom insbesondere von der Druckdifferenz zwischen dem ersten Sektor und dem zweiten Sektor abhängt. Durch das Vorsehen einer die Abtrennung vollständig überdeckenden Zwischenkammer, in welcher mit Hilfe der Fördereinrichtung ein Unterdruck gegenüber dem in dem ersten Sektor herrschenden ersten Druck eingestellt wird, welcher größer als und vorzugsweise gleich groß wie der in dem zweiten Sektor herrschende zweite Druck ist, kann erreicht werden, dass die Druckdifferenz zwischen dem in der Zwischenkammer eingestellten Druck und dem in dem zweiten Sektor herrschenden Druck im Vergleich zu der Druckdifferenz zwischen dem in dem ersten Sektor herrschenden ersten Druck und dem in dem zweiten Sektor herrschenden zweiten Druck reduziert und im Idealfall sogar aufgehoben wird. Auf diese Weise ist der durch die Abtrennung auftretende Leckagestrom reduziert bzw. im Idealfall sogar eingestellt.

Erfindungsgemäß wird der in der Zwischenkammer eingestellte Druck, welcher gegenüber dem in dem ersten Sektor herrschenden ersten Druck ein Unterdruck ist, dadurch erzeugt, dass mit Hilfe der Fördereinrichtung Fluid von der Zwischenkammer in den ersten Sektor gefördert wird. Die Fördereinrichtung kann beispielsweise ein Ventilator oder eine Pumpe sein. Im Vergleich zu einem System, bei welchem keine Zwischenkammer vorgesehen ist, strömt bei der erfindungsgemäßen Lösung pro Zeiteinheit eine reduzierte Menge an Fluid in den zweiten Sektor. Im Idealfall, d.h. wenn der in der Zwischenkammer eingestellte Druck identisch mit dem in dem zweiten Sektor herrschenden zweiten Druck ist, kann ein Übertritt von Fluid aus der Zwischenkammer und aus dem ersten Sektor in den zweiten Sektor vollständig verhindert werden. Dieser Aspekt ist insbesondere für Anwendungen von Vorteil, bei welchen eine leckagebedingte Vermischung des sich in dem ersten Sektor befindenden Fluids mit dem sich in dem zweiten Sektor befindenden Fluids zu verhindern ist.

Bei einer bevorzugten Ausführungsform der erfindungsgemäßen Lösung ist vorgesehen, dass die Seitenwände der Zwischenkammer durch die Abtrennung einerseits und durch eine von der Abtrennung in Richtung des ersten Sektors beabstandete zusätzliche Abtrennung andererseits gebildet werden. Als zusätzliche Abtrennung kommt beispielsweise ein Trennblech in Frage. Für die Abtrennung, die den ersten Sektor und den zweiten Sektor voneinander trennt, kann die Wand der Raumhülle verwendet werden.

Wie bereits angedeutet, handelt es sich bei der den ersten von dem zweiten Sektor abtrennenden Abtrennung (Wand der Raumhülle) insbesondere um eine Trennwand, die Undichtigkeiten beispielsweise an Bereichen der Trennwand aufweist, durch welche baulich bedingte Teile einer Anlagentechnik geführt werden. Für die zusätzliche Abtrennung, die eine Seitenwand der Zwischenkammer ausbildet, ist es keinesfalls erforderlich, dass es sich hierbei um eine vollständig fluiddichte Abtrennung handelt. Vielmehr ist es sogar von Vorteil, wenn als zusätzliche Abtrennung eine Trennwand verwendet wird, die Undichtigkeiten aufweist, durch welche (gewollt oder ungewollt) Fluid aus dem ersten Sektor in die Zwischenkammer gelangen kann. Durch einen derartigen Fluidübertritt von dem ersten Sektor zu der Zwischenkammer kann sichergestellt werden, dass die Fördereinrichtung, mit weicher Fluid von der Zwischenkammer in den ersten Sektor gefördert wird, stets in ihrem vorzugweise optimalen Arbeitsbereich betrieben wird.

Die Fördereinrichtung steht in einer bevorzugten Realisierung der erfindungsgemäßen Vorrichtung über ein Leitungssystem mit der Zwischenkammer in Fluidverbindung, wobei dieses Leitungssystem an der Saugseite der Fördereinrichtung vorgesehen ist. Die Druckseite der Fördereinrichtung steht über ein weiteres Leitungssystem mit dem ersten Sektor in Verbindung.

In einer besonders bevorzugten Realisierung der erfindungsgemäßen Vorrichtung weist diese ferner eine Sensoreinrichtung mit einem ersten Drucksensor und einem zweiten Drucksensor auf, wobei der erste Drucksensor zum Erfassen des in dem zweiten Sektor herrschenden zweiten Druckes und der zweite Drucksensor zum Erfassen des in der Zwischenkammer mit Hilfe der Fördereinrichtung erzeugten Druckes dient. Des Weiteren ist bevorzugt eine Steuereinrichtung vorgesehen, welche ausgelegt ist, in Abhängigkeit von den mit Hilfe der Sensoreinrichtung erfassten Druckwerte die Fördereinrichtung anzusteuern, um die Förderleistung und somit die pro Zeiteinheit aus der Zwischenkammer abgeführte und in den ersten Sektor zurückgeführte Fluidmenge zu regeln. Im Einzelnen ist dabei die Steuereinrichtung ausgelegt, die Fördereinrichtung derart anzusteuern, dass die Differenz zwischen dem erfassten Wert des in dem zweiten Sektor herrschenden zweiten Druckes und dem erfassten Wert des in der Zwischenkammer erzeugten Druckes einen vorab festgelegten oder festlegbaren Wert annimmt. Wie bereits ausgeführt, ist dieser vorab festgelegte oder festlegbare Wert kleiner als der Wert des in dem ersten Sektor herrschenden ersten Druckes und größer als und (in idealer Weise) gleich groß wie der Wert des in dem zweiten Sektor herrschenden zweiten Druckes.

Über die Steuereinrichtung wird die Förderleistung der Fördereinrichtung vorzugweise automatisch eingeregelt. Selbstverständlich ist es aber auch denkbar, dass dies über eine externe Eingabe, beispielsweise von dem Bediener der Vorrichtung vorgenommen wird.

Wie bereits angedeutet, ist es bevorzugt, wenn die zusätzliche Abtrennung, welche eine Seitenwand der Zwischenkammer bildet, nicht vollständig fluiddicht ausgebildet ist, sondern Undichtigkeit aufweist, über welche ein Fluidübertritt von dem ersten Sektor in die Zwischenkammer möglich ist. Für den Fall, dass als zusätzliche Abtrennung beispielsweise ein Trennblech verwendet wird, d.h. eine Trennwand, die konstruktionsbedingt nur eine geringe Fluiddurchlässigkeit gewährleistet, ist es bevorzugt, wenn ferner eine Einrichtung zur Druckentlastung vorgesehen ist, mit welcher bei Bedarf eine offene Fluidverbindung zwischen der Zwischenkammer und dem ersten Sektor bereitgestellt werden kann, um somit ein gewolltes Überströmen von Fluid aus dem ersten Sektor zu der Zwischenkammer zu ermöglichen.

Denkbar hierbei ist es, für die Druckentlastung beispielsweise eine Druckentlastungsklappe zu verwenden, die sich vorzugsweise automatisch öffnet, wenn die Differenz zwischen dem in dem ersten Sektor herrschenden ersten Druck und dem in der Zwischenkammer erzeugten Druck einen vorab festgelegten oder festlegbaren Wert überschreitet. Auf diese Weise kann sichergestellt werden, dass der mit Hilfe der Fördereinrichtung in der Zwischenkammer erzeugte Unterdruck gegenüber dem in dem ersten Sektor herrschenden ersten Druck nicht einen vorab festgelegten Wert unterschreitet. Insbesondere wird dabei der Anforderung Sorge getragen, dass für den optimalen Betrieb der Fördereinrichtung ein hinreichend hoher Druck in der Zwischenkammer vorliegt. Dies ist vor allem für eine kontrollierbare und definierte Förderleistung der Fördereinrichtung und somit für einen wirksamen Betrieb der erfindungsgemäßen Vorrichtung erforderlich.

Um eine Mindestdurchlassigkeit der zusätzlichen Abtrennung sicherzustellen, kommen anstelle einer Druckentlastungsklappe selbstverständlich auch andere Einrichtungen zur Druckentlastung in Frage. Insbesondere ist jedoch eine Einrichtung bevorzugt, welche ausgelegt ist, die pro Zeiteinheit von dem ersten Sektor zu der Zwischenkammer überströmende Fluidmenge in kontrollierter Weise einzustellen. Wie bereits angedeutet, sollte die pro Zeiteinheit überströmende Fluidmenge an den optimalen Arbeitsbetrieb der Fördereinrichtung angepasst sein.

Im Folgenden wird die Erfindung anhand von Ausführungsformen unter Bezugnahme auf die beigefügten Zeichnungen näher erläutert.

Es zeigen:
- Fig. 1: eine schematische Ansicht einer Ausführungsform der erfindungsgemäßen Vorrichtung zum Minimieren eines ungewollten Fluidübertritts von einem ersten Sektor zu einem zweiten Sektor, welche mit einer nicht dichten Ab- trennung abgetrennt sind;
- Fig. 2: eine schematische Ansicht eines Wärmetauschersystems zum Übertragen von Warmeenergie zwischen einem warmen Fluid und einem kalten Fluid, wobei das Wärmetauschersystem zum Minimieren eines ungewollten Fluid- übertritts von einem ersten Sektor, der von dem warmen Fluid durchströmt wird, zu einem zweiten Sektor, der von dem kalten Fluid durchströmt wird, eine Ausführungsform der erfindungsgemäßen Vorrichtung aufweist;
- Fit. 3: das in Fig. 2 dargestellte Wärmetauschersystem ohne die erfindungsgemäße Vorrichtung zum Minimieren eines ungewollten Fluidübertritts von dem von dem warmen Fluid durchströmten ersten Sektor zu dem von dem kal- ten Fluid durchströmten zweiten Sektor; und
- Fig. 4: eine Flussskizze zum Erläutern der Wirkungsweise der erfindungsgemäßen Vorrichtung, wenn diese - wie in Fig. 2 schematisch dargestellt - bei einem Wärmetauschersystem gemäß Fig. 3 zum Einsatz kommt.

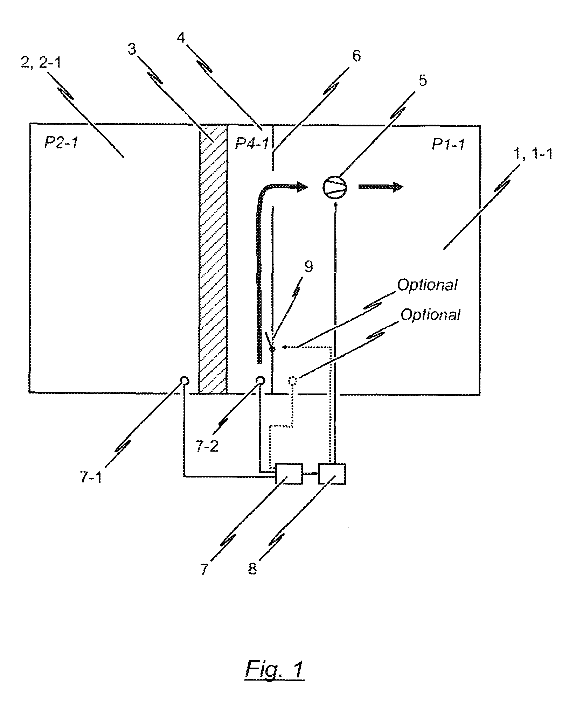

Fig. 1 zeigt in einer schematischen Ansicht eine bevorzugte Ausführungsform der erfindungsgemäßen Vorrichtung zum Minimieren eines ungewollten Fluidübertritts von einem ersten Sektor 1 zu einem zweiten Sektor 2, welche mit einer nicht fluiddichten Abtrennung 3 abgetrennt sind. Die Abtrennung 3 ist beispielsweise eine als Trennwand fungierende Gebäudewand einer Raumhülle. Bei der in Fig. 1 dargestellten Ausführungsform ist der erste Sektor 1 als umschlossener Raum ausgebildet, welcher durch eine Raumhülle begrenzt wird, wobei die Abtrennung 3 ein Teil der Raumhülle darstellt.

Unmittelbar angrenzend an den ersten Sektor 1 befindet sich der zweite Sektor 2, der ebenfalls als ein mit einer Raumhülle umschlossener Raum ausgebildet sein kann, wobei die Abtrennung 3 gleichzeitig auch eine Wand der den zweiten Sektor 2 umgebenden Raumhülle ausbildet. Selbstverständlich ist es aber auch denkbar, dass zumindest einer der beiden Sektoren 1, 2 nicht als ein mit einer Raumhüllc umschlossener Raum ausgebildet ist. Wesentlich ist einzig und allein, dass es sich bei den Sektoren 1, 2 um zwei aneinander angrenzende Bereiche handelt, die über eine gemeinsame Trennwand (Abtrennung 3) voneinander getrennt sind. Ebenfalls ist es wesentlich, dass es sich bei der Abtrennung 3 um eine Trennwand handelt, die nicht vollständig fluidundurchlässig ausgebildet ist. Vielmehr sind (in der Darstellung gemäß Fig. 1 nicht explizit dargestellte) Undichtigkeiten in der Abtrennung 3 vorgesehen, welche eine Fluidverbindung zwischen dem ersten Sektor 1 und dem zweiten Sektor 2 bilden.

Als Undichtigkeiten kommen in der Abtrennung 3 bewusst vorgesehene Öffnungen, aber auch ungewollte Undichtigkeiten in Frage, über welche ein ungewollter bzw. unkontrollierter Austausch zwischen einem in dem ersten Sektor 1 vorgesehenen ersten Fluid 101 und einem in dem zweiten Sektor 2 Vorgesehenen zweiten Fluid 102 möglich ist. Als erste und zweite Fluide 101, 102 kommen insbesondere gasförmige aber auch flüssige Wedien mit gleicher oder aber auch unterschiedlicher chemischer Zusammensetzung in Frage. Beispielsweise ist denkbar, dass es sich bei dem ersten Fluid 101, welches sich in dem ersten Sektor 1 befindet, um gasförmiges Stickstoff handelt, während das zweite Fluid 102, weiches sich in dem zweiten Sektor 2 befindet, normale Luft sein kann, d.h. ein Gasgemisch mit den Hauptbestandteilen Stickstoff (78 Vol.-%), Sauerstoff (20,9 Vol.-%), Argon (0,9 Vol.-%) und Rest-Spurengase.

Die in der Darstellung gemäß Fig. 1 schematisch gezeigte Vorrichtung wurde entwickelt, um einen ungewollten Fluidübertritt von dem ersten Sektor 1 zu dem zweiten Sektor 2 zu minimieren, wenn in dem ersten Sektor 1 ein erster Druck P1-1 und in dem zweiten Sektor 2 ein im Vergleich zum ersten Druck P1-1 niedrigerer zweiter Druck P2-1 herrscht. Ohne eine besondere Maßnahme würde sich - aufgrund der über der Abtrennung 3 herrschenden Druckdifferenz - ein durch die Undichtigkeiten der Abtrennung 3 fließender Leckagestrom einstellen, infolgedessen ein (ungewollter) Fluidübertritt von dem ersten Sektor 1 zu dem zweiten Sektor 2 stattfindet. Wenn keine den ungewollten Fluidübertritt kompensierende Maßnahme vorgenommen wird, würde der Leckagestrom zu einer Abnahme des ursprünglich in dem ersten Sektor 1 eingestellten ersten Druckes P1-1 sowie zu einer Vermischung der beiden Fluide 101, 102 in dem zweiten Sektor 2 führen.

Um dies zu verhindern, ist erfindungsgemäß an der Abtrennung 3 eine Zwischenkammer 4 ausgebildet, welche die beiden Sektoren 1, 2 vollständig voneinander trennt. Wie in Fig. 1 gezeigt, kommt bei der dargestellten Ausführungsform der erfindungsgemäßen Vorrichtung eine zusätzliche Abtrennung 6 beispielsweise in Gestalt einer zusätzlichen Trennwand oder in Gestalt eines Trennbleches zum Einsatz, wobei diese zusätzliche Abtrennung 6 in Richtung des ersten Sektors 1 beabstandet ist. Als Abstand zwischen der Abtrennung 3 und der zusätzlichen Abtrennung 6 genügt bereits ein Spalt von beispielsweise 10 cm Breite. Wie bereits zuvor angedeutet, ist es nicht zwingend erforderlich, dass die zusätzliche Abtrennung 6, welche eine Seitenwand der Zwischenkammer 4 bildet, vollständig fluidundurchlässig ist. Vielmehr ist es sogar erwünscht, dass ein gewisser Fluidübertritt zwischen dem ersten Sektor 1 und der Zwischenkammer 4 möglich ist.

Die erfindungsgemäße Vorrichtung gemäß der in Fig. 1 dargestellten Ausführungsform weist ferner eine Fördereinrichtung 5, beispielsweise in Gestalt eines Ventilators oder in Gestalt einer Pumpe, auf. Über ein in Fig. 1 nicht explizit dargestelltes Leitungssystem steht die Fördereinrichtung 5 einerseits mit der Zwischenkammer 4 und andererseits mit dem ersten Sektor 1 in Verbindung, um Fluid 101 von der Zwischenkammer 4 in den ersten Sektor 1 fördern zu können.

Die Wirkungsweise der erfindungsgemäßen Vorrichtung beruht darauf, die Fördereinrichtung 5 geeignet anzusteuern, so dass in der Zwischenkammer 4 ein Unterdruck gegenüber dem in dem ersten Sektor 1 herrschenden ersten Druck P1-1 erzeugt wird. Im Idealfall wird die Förderleistung der Fördereinrichtung 5 derart eingeregelt, dass der in der Zwischenkammer 4 erzeugte Druck P4-1 gleich groß wie der in dem zweiten Sektor 2 herrschende zweite Druck P2-1 ist. In diesem (Ideal-)Fall beträgt die Differenz zwischen dem in der Zwischenkammer 4 herrschenden Druck P4-1 und dem zweiten Sektor 2 herrschenden zweiten Druck P2-1 Null, so dass ein aufgrund einer Druckdifferenz auftretender Leckagestrom durch die Abtrennung 3 nicht mehr auftreten kann.

Die Erfindung ist allerdings nicht auf den zuvor beschriebenen Idealfall eingeschränkt, in welchem der in der Zwischenkammer 4 erzeugte Druck P4-1 gleich groß wie der in dem zweiten Sektor 2 herrschende zweite Druck P2-1 ist. Vielmehr genügt es bereits, wenn der in der Zwischenkammer 4 erzeugte Druck P4-1 einen Wert annimmt, welcher zwischen dem in dem ersten Sektor 1 herrschenden ersten Druck P1-1 und dem in dem zweiten Sektor 2 herrschenden zweiten Druck P2-1 liegt. Bereits in diesem Fall kann ein ungewollter Fluid-übertritt durch die Undichtigkeiten der Abtrennung 3 reduziert werden, da die über die Abtrennung 3 abfallende Druckdifferenz, welche als treibende Kraft für den Leckagestrom durch die Abtrennung 3 dient, im Vergleich zu Sektoren, bei welchen keine Zwischenkammer vorgesehen ist, reduziert wird.

Wie in Fig. 1 dargestellt, wird mit der Fördereinrichtung 5 das aus der Zwischenkammer 4 geförderte Fluid 101 in den ersten Sektor 1 rückgeführt. Auf diese Weise wird sichergestellt, dass aus dem ersten Sektor 1 kein Fluid 101 austreten und über die Abtrennung 3 in den zweiten Sektor 2 gelangen kann. Mit der erfindungsgemäßen Vorrichtung kann somit ein ungewollte Fluidübertritt verhindert oder zumindest reduziert werden, auch wenn nicht nur die Abtrennung 3, sondern auch die zusätzliche Abtrennung 6, welche eine Seitenwand der Zwischenkammer 4 ausbildet, fluiddurchlässig sind.

Vorzugsweise ist die erfindungsgemäße Vorrichtung als ein automatisch arbeitendes System ausgeführt, bei welchem die Förderleistung der Fördereinrichtung 5 selbstständig an die herrschenden bzw. sich einstellenden Druckwerte angepasst wird.

In einer bevorzugten Ausführungsform der erfindungsgemäßen Lösung, die auch bei dem in der Darstellung gemäß Fig. 1 gezeigten Beispiel Einzug gefunden hat, ist eine Sensoreinrichtung 7 vorgesehen, welche einen ersten Drucksensor 7-1 und einen zweiten Drucksensor 7-2 aufweist. Der erste Drucksensor 7-1 ist in dem zweiten Sektor 2 angeordnet und dient zum Erfassen des in dem zweiten Sektor 2 herrschenden zweiten Druckes P2-1. Der zweite Drucksensor 7-2 befindet sich in der Zwischenkammer 4 und dient zum Erfassen des dort mit Hilfe der Fördereinrichtung 5 erzeugten Druckes P4-1.

Die von den beiden Drucksensoren 7-1, 7-2 bzw. von der Sensoreinrichtung 7 erfassten Druckwerte werden eine Steuereinrichtung 8 zugeführt, die mit der Fördereinrichtung 5 in Verbindung steht, um die Förderleistung dieser in Abhängigkeit von den erfassten Druckwerten entsprechend einzustellen. Im Einzelnen ist die Steuereinrichtung 8 ausgelegt, die Fördereinrichtung 5 derart anzusteuern, dass die Differenz zwischen dem erfassten Wert des in dem zweiten Sektor 2 herrschenden zweiten Druckes P2-1 und dem erfassten Wert des in der Zwischenkammer 4 mit Hilfe der Fördereinrichtung 5 erzeugten Druckes P4-1 einen vorab festgelegten oder festlegbaren Wert annimmt, der in idealer Weise mit dem Wert des in dem zweiten Sektor 2 herrschenden zweiten Druckes P2-1 identisch oder zumindest zwischen dem Wert des in dem zweiten Sektor 2 herrschenden zweiten Druckes P2-1 und dem Wert des in dem ersten Sektor 1 herrschenden ersten Druckes P1-1 liegt.

In der schematischen Ansicht gemäß Fig. 1 ist strichpunktiert dargestellt, dass die Sensoreinrichtung 7 optional ferner einen dritten Drucksensor zum Erfassen des in dem ersten Sektor 1 herrschenden ersten Druckes P1-1 aufweisen kann. Dieser erfasste Druckwert kann der Steuereinrichtung 8 zugeführt werden, um entscheiden zu können, ob der in der Zwischenkammer 4 erzeugte Druck P4-1 den vorab festgelegten oder festlegbaren Wert angenommen hat.

Wie bereits angedeutet, kann die zusätzliche Abtrennung 6, welche eine Seitenwand der Zwischenkammer 4 ausbildet, konstruktionsbedingte und/oder ungewollte Undichtigkeiten aufweisen. In bevorzugter Weise sollte die zusätzliche Abtrennung 6 im Hinblick auf ihre Dichtigkeit so ausgebildet sein, dass die pro Zeiteinheit von dem ersten Sektor 1 zu der Zwischenkammer 4 überströmende Fluidmenge einen Wert annimmt, der einen optimalen Betrieb der Fördereinrichtung 5 gewährleistet. Für den Fall, dass die zusätzliche Abtrennung 6 relativ fluiddicht ausgebildet ist, kann zum Einstellen der pro Zeiteinheit von dem ersten Sektor 1 zu der Zwischenkammer 4 überströmenden Fluidmenge eine Einrichtung 9 zur Drucklastung verwendet werden.

Bei der in Fig. 1 dargestellten Ausführungsform der erfindungsgemäßen Lösung kommt als Einrichtung 9 zur Druckentlastung eine mechanisch arbeitende Druckentlastungklappe zum Einsatz, über welche die pro Zeiteinheit vom ersten Sektor 1 zu der Zwischenkammer 4 überströmende Fluidmenge automatisch und in Abhängigkeit von der vorliegenden Druckdifferenz zwischen dem in dem ersten Sektor 1 herrschenden ersten Druck P1-1 und dem in der Zwischenkammer 4 erzeugten Druck P4-1 eingestellt wird. Unter der Voraussetzung, dass der in dem ersten Sektor 1 herrschende erste Druck P1-1 als konstant anzusehen ist, ist die bei der in Fig. 1 dargestellten Ausführungsform der erfindungsgemäßen Lösung zum Einsatz kommende Druckentlastungsklappe 9 ausgelegt, die pro Zeiteinheit von dem ersten Sektor 1 zu der Zwischenkammer 4 überströmende Fluidmenge automatisch in Abhängigkeit von dem momentanen Wert des in der Zwischenkammer 4 herrschenden Druckes P4-1 einzustellen.

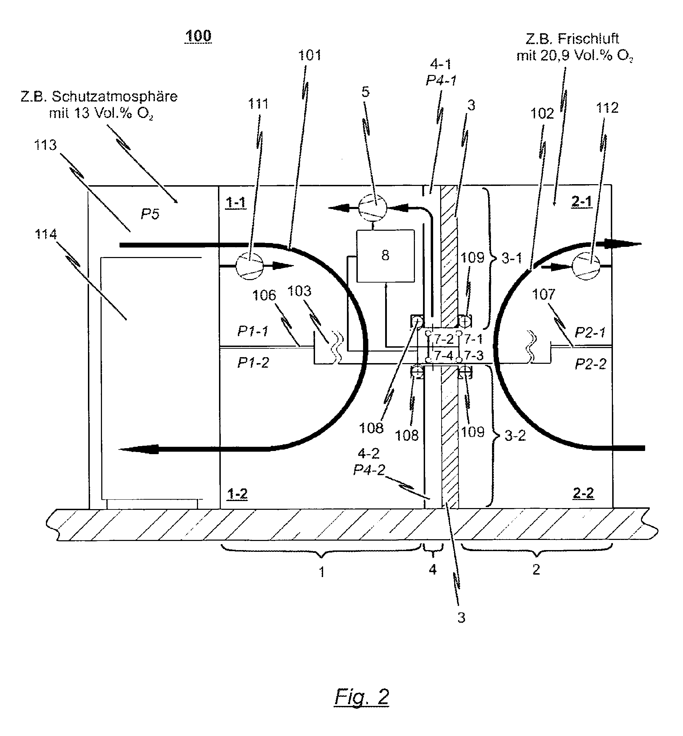

Nachfolgend wird unter Bezugnahme auf Fig. 2 ein Wärmetauschersystem 100 beschrieben, bei welchem die erfindungsgemäße Vorrichtung zum Einsatz kommt, um einen ungewollten Fluidübertritt zwischen den Wärmetauschermedien (erstes bzw. warmes Fluid 101 und zweites bzw. kaltes Fluid 102) zu minimieren. Unabhängig davon, dass die zwischen den Wärmetauschermedien 101, 102 vorgesehene Abtrennung (welche nachfolgend "erste Abtrennung 3" bezeichnet wird) Undichtigkeiten aufweist, über welche eine Stoffübertragung möglich ist, kann mit der erfindungsgemäßen Vorrichtung eine Minimierung des Fluidübertritts erzielt werden.

Bei dem nachfolgend unter Bezugnahme auf Fig. 2 beschriebenen Wärmetauschersystem 100 handelt es sich um ein System, bei welchem als Wärmeübertrager ein Wärmerad bzw. Rotor 103 zum Einsatz kommt. Hierbei handelt es sich lediglich um eine beispielhafte Beschreibung eines als Regenerator ausgebildeten Wärmeübertragers. Die Verwendung der erfindungsgemäßen Vorrichtung ist insbesondere nicht auf ein Wärmetauschersystem 100 beschränkt, bei welchem eine halbdirekte Wärmeübertragung mit Hilfe eines Regenerators stattfindet. Vielmehr kann die erfindungsgemäße Lösung selbstverständlich auch in einem Wärmeübertrager angewandt werden, bei welchem durch Verwendung eines Rekuperator eine indirekte Wärmeübertragung stattfindet.

Auch ist die erfindungsgemäße Lösung nicht einzig und allein auf die Verwendung in einem Wärmetauschersystem beschränkt. Wie es den Ausführungen zu dem in Fig. 1 dargestellten Ausführungsbeispiel entnommen werden kann, eignet sich die erfindungsgemäße Lösung grundsätzlich für alle Systeme, bei welchen zwei Sektoren mit einer fluidundichten Abtrennung abgetrennt sind, wobei in dem ersten Sektor ein Druck herrscht, welcher größer als der in dem zweiten Sektor herrschende Druck ist.

Es sei darauf hingewiesen, dass zur Erläuterung der Wirkungsweise der erfindungsgemäßen Vorrichtung ein Warmetauschersystem gewählt wird, bei welchem mit Hilfe eines Rotors 103 eine halbdirekte Wärmeübertragung zwischen einem in dem ersten Sektor 1 strömenden warmen Fluid 101 und einem in dem zweiten Sektor 2 strömenden kalten Fluid 102 bewirkt wird. Da bei derartigen Rotationswärmeaustauschern konstruktionsbedingt stets Undichtigkeiten zwischen dem Rotor einerseits und der Abtrennung 3 andererseits auftreten, eignet sich ein Wärmetauschersystem, bei welchem die erfindungsgemäße Lösung zum Einsatz kommt, besonders gut, um die mit der erfindungsgemäße Lösung erzielbaren Vorteile aufzuzeigen.

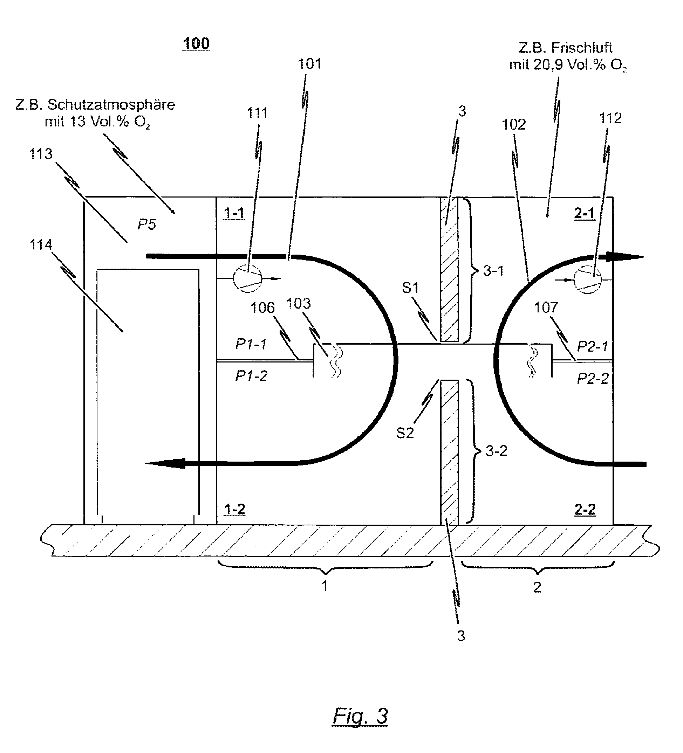

Bevor allerdings auf die Wirkungsweise der in einem Wärmetauschersystem zum Einsatz kommenden Vorrichtung gemäß der vorliegenden Erfindung näher eingegangen wird, soll zunächst unter Bezugnahme auf die Darstellung in Fig. 3 auf die Funktionsweise eines herkömmlichen Rotationswärmeaustauschers 100 eingegangen werden.

Das in Fig. 3 schematisch dargestellte und aus dem Stand der Technik allgemein bekannte Wärmetauschersystem 100 ist wie folgt aufgebaut: Das Wärmetauschersystem 100 weist einen ersten Strömungssektor (nachfolgend "erster Sektor 1" bezeichnet) auf, welcher von einem warmen Fluid 101 durchströmt wird. Ferner ist ein zweiter Strömungssektor (nachfolgend "zweiter Sektor 2" genannt) vorgesehen, der von einem kalten Fluid 102 durchströmt wird.

Beispielsweise ist es denkbar, dass für den warmen Fluidstrom die Abluft von EDV-Einrichtungen 114, welche in einem an den ersten Sektor 1 angrenzenden Serverraum 113 angeordnet sind, verwendet wird. Zur Kühlung derartiger EDV-Einrichtungen 114 ist es denkbar, mit Hilfe des Wärmetauschersystems 100 die (warme) Abluft aus dem Serverraum 113 mit Hilfe eines ersten Ventilatorblocks 111 dem Wärmetauschersystem 100 zuzuführen. In dem Warmetauschersystem 100 wird Wärmeenergie von dem warmen Fluid 101 über einen Wärmeübertrager 103 auf den durch den zweiten Sektor 2 strömenden kalten Fluidstrom 102 übertragen. Nach dem Passieren des Wärmeübertragers 103 wird der abgekühlte Fluidstrom 101 wieder dem Serverraum 109 zugeführt.

Der als Kühlmedium verwendete kalte Fluidstrom 102 fließt durch den zweiten Sektor 2 des Wärmetauschersvstems 100, wobei ein zweiter Ventilatorblock 112 zum Einsatz kommt, um beispielsweise Außenluft für die Kühlung des Warmeübertragers 103 anzusaugen und diese nach dem Passieren des Wärmeübertragers 103 in erwärmter Form wieder an die Außenatmosphäre abzugeben.

Der erste Sektor 1, durch welches das in dem Wärmetauschersystem 100 abzukühlende warme Fluid 101 strömt, und der zweite Sektor 2, durch welchen dass zu erwärmende kalte Fluid 102 strömt, sind über eine als Trennwand ausgebildete erste Abtrennung 3 voneinander räumlich getrennt. In dieser ersten Abtrennung 3 ist eine Rotoröffnung 105 vorgesehen, durch welche sich der bei der in Fig. 3 dargestellten Ausführungsform des Wärmetauschersystems 100 als Wärmeübertrager zum Einsatz kommende Rotor 103 erstreckt.

Bei dem Rotor 103 handelt es sich um ein drehbar gelagertes Wärmerad, wobei die Drehachse durch die in der ersten Abtrennung 3 ausgebildete Rotoröffnung 105 läuft. Der Rotor 103 besteht aus zahlreichen zur Drehachse parallelen Kanäle. Bei der Wärmeübertragung wird die Fähigkeit der Wände dieser Kanäle ausgenutzt, thermische Energie (Wärme) zu speichern. Durch die Kanäle, welche sich in der Hälfte des Rotors 103 befinden, die in dem ersten Sektor 1 liegt, wird die warme Abluft der EDV-Einrichtungen 114 (warmes Fluid 101) geblasen. Auf diese Weise werden die Wände der entsprechenden Kanäle aufgewärmt.

Beim Betrieb des Rotationswärmeübertragers dreht sich der Rotor 103 weiter, so dass die aufgewärmten Kanäle den Bereich in dem zweiten Sektor 2 erreichen, wo sie von der kalten Außenluft (kaltes Fluid 102) durchströmt werden. An den warmen Wänden der Kanäle wird das kalte Fluid 102 erwärmt, was zu einem Abkühlen der Wände führt.

Für den Betrieb des Warmetauschersystems 100 gemäß Fig. 3 ist es erforderlich, in dem ersten Sektor 1 die Strömung des warmen Fluids 101 durch die entsprechenden Kanäle des Rotors 103 zu leiten, welche sich gerade in dem ersten Sektor 1 befinden. In gleicher Weise ist dafür Sorge zu tragen, dass der Strom des kalten Fluids 102 in dem zweiten Sektor durch die Kanäle des Rotors 103 geführt wird, welche sich gerade in dem zweiten Sektor 2 befinden.

Um dies zu erreichen, ist das Wärmetauschersystem 100 mit einer zweiten und dritten Abtrennung 106, 107 ausgerüstet. Die zweite Abtrennung 106 ist in dem ersten Sektor 1 derart angeordnet, dass der erste Sektor 1 in eine erste Warmfluidkammer 1-1 und in eine zweite Warmfluidkammer 1-2 eingeteilt wird. Die erste Warmfluidkammerr 1-1 steht mit der zweiten Warmfluidkammer 1-2 über sich in dem ersten Sektor 1 befindenden Kanäle des Rotors 103 in Fluidverbindung.

Andererseits ist die dritte Abtrennung 107 in dem zweiten Sektor 2 derart angeordnet, dass der zweite Sektor 2 in eine erste Kaltfluidkammer 2-1 und in eine zweite Kaltfluidkammer 2-2 eingeteilt wird, wobei diese beiden Kaitfluidkammern 2-1, 2-2 über sich in dem zweiten Sektor 2 befindenden Kanäle des Rotors 103 in Fluidverbindung stehen.

Der Darstellung in Fig. 3 ist insbesondere zu entnehmen, dass die zweite Abtrennung 106 und die dritte Abtrennung 107 derart angeordnet sind, dass sie sich radial zum Rotor 103 und senkrecht zur Drehachse des Rotors 103 erstrecken.

Da bei dem Warmetauschersystem 100 der drehbar gelagerte Rotor 103, welcher bei einer Drehung den ersten und zweiten Sektor 1, 2 durchläuft, sowohl in dem ersten als auch in dem zweiten Sektor 1, 2 ein Strömungswiderstand darstellt, den die jeweiligen Fluidströme passieren müssen, stellt sich in der ersten Wärmetluidkammer 1-1 ein erster Druck P1-1 und in der über den Rotor 103 und der zweiten Abtrennung, 106 von der ersten Warmfluidkammer 1-1 abgetrennten zweiten Warmtfuidkammer 1-2 ein dritter Druck P1-2 ein, wobei der dritte Druck P1-2 geringer als der erste Druck P1-1 ist.

Da das Wärmetauschersystem 100 im Gegenstromprinzip betrieben wird, herrscht in der ersten Kaltfluidkammer 2-1 ein Druck (zweiter Druck P2-1), welcher niedriger als der in der zweiten Kaltfluidkammer 2-2 herrschende Druck (vierter Druck P2-2) ist.

Demnach tritt zwischen der ersten Warmfluidkammer 1-1 und der ersten Kaltfluidkammer 2-1, welche über die erste Abtrennung 3 voneinander getrennt sind, eine Druckdifferenz auf, wobei der in der ersten Warmfluidkammer 1-1 herrschende erste Druck P1-1 größer als der in der ersten Kaltfluidkammer 2-1 herrschende zweite Druck P2-1 ist. In gleicher Weise tritt auch zwischen der zweiten Warmfluidkammer 1-2 und der zweiten Kaltfluidkammer 2-2 eine Druckdifferenz auf. Der in der zweiten Kaltfluidkammer 2-2 herrschende vierte Druck P2-2 kann größer als der in der zweiten Warmfluidkammer 1-2 herrschende zweite Druck P1-2 sein.

Da die erste Abtrennung 3 keine fluiddichte Trennwand darstellt, mit welcher der erste Sektor 1 und der zweite Sektor 2 des Wärmetauschersystems stoffdicht voneinander getrennt werden, bewirkt die zwischen einer Warmfluidkammer 1-1, 1-2 und einer benachbart hierzu angeordneten Kalttluidkalnmer 2-1, 2-2 auftretende Druckdifferenz einen Leckagestrom, wobei das warme Fluid 101 aus der ersten Warmfluidkammer 1-1 durch Undichtigkeiten und insbesondere durch einen an der Nabe des Rotors 103 vorgesehene erste Spaltöffnung S1 zu der benachbarten ersten Kaltfluidkammer 2-1 strömt.

Andererseits kann eine hierzu entgegengesetzte Strömung in dem unteren Bereich des Wärmetauschersystems 100 auftreten, bei welcher kaltes Fluid 102 aus der zweiten Kaltfluidkammer 2-2 durch Undichtigkeiten der ersten Abtrennung 3 und insbesondere durch die an der Nabe des Rotors 103 vorgesehene zweite Spaltöffnung S2 in die zweite Warmfluidkammer 1-2 strömt.

Demnach kann im Betrieb des aus dem Stand der Technik bekannten und in Fig. 3 schematisch dargestellten Wärmetauschersystem nicht verhindert werden, das ein Stoffaustausch zwischen dem ersten Sektor 1 und dem zweiten Sektor 2 auftritt.

Die erfindungsgemäße Lösung, wie sie zuvor anhand eines Ausfüliruiigsbeispiels unter Bezugnahme auf die Darstellung in Fig. 1 beschrieben wurde, eignet sich bei der Verwendung eines beispielsweise in Fig. 3 dargestellten Wärnietauschersystems 100, um die im Betrieb des Wärmetauschersystems 100 auftretenden Fluidübertritte zwischen dem ersten Sektor 1 und dem zweiten Sektor 2 wirksam zu verhindern.

Bei der in Fig. 2 dargestellten Ausführungsform handelt es sich um ein WärmetauscherSystem 100 gemäß Fig. 3, wobei allerdings die erfindungsgemäße Lösung zum Einsatz kommt, um zu verhindern, dass im Betrieb des Wärmctauschersystems 100 ein ungewollter Fluidübertritt von dem ersten Sektor 1 zu dem zweiten Sektor 2 auftritt.

Im Einzelnen ist hierbei vorgesehen, dass in dem ersten Sektor 1 (Warmluftzone des Wärnictauschersytems) unmittelbar angrenzend an die erste Abtrennung 3, über welche die Warmluftzone des Warmetauschersystems 1 von der Frischluftzone (zweiter Sektor 2) getrennt wird, die bereits unter Bezugnahme auf die Ausführungsform gemäß Fig. 1 beschriebene Zwischenkammer 4 vorgesehen wird. Hierfür kann beispielsweise ein um beispielsweise 10 cm in Richtung des ersten Sektors 1 beabstandetes Trennblech verwendet werden, welches eine Seitenwand der Zwischenkammer 4 ausbildet. Die erste Abdeckung 3 stellt dabei die entsprechend gegenüberliegende Seitenwind der Zwischenkammer 4 dar.

Um eine Rotation des Rotors 103 um die Drehachse im Betrieb des Warmetauschersystems 100 zu ermöglichen, erstreckt sich die Rotoröffnung 105 bei der in Fig. 2 dargestellten Ausführungsform des Warmetauschersystems 100 sowohl durch die erste Abtrennung 3 als auch durch die zusätzliche Abtrennung 6 (Trennblech), welche die den ersten Sektor 1 zugewandte Seitenwand der Zwischenkammer 4 darstellt. Nach wie vor befindet sich in dem Bereich der Nabe des Rotors 103 eine obere Spaltöffnung (erster Spalt S1), über welche eine offene Fluid Verbindung zwischen der ersten Warmfluidkammer 1-1 und der ersten Kaltfluidkammer 2-1 gebildet wird, und eine untere Spaltöffnung (zweiter Spalt S2), die eine offene Fluidverbindung zwischen der zweiten Warmfluidkammer 1-2 und der zweiten Kaltfluidkammer 2-2 darstellt.

Demnach liegt zwischen dem ersten Sektor 1 und dem zweiten Sektor 2 nach wie vor eine Trennwand (erste Abtrennung 3) vor, die Undichtigkeiten aufweist, durch welche ein stofflicher Austausch zwischen den jeweils in dem ersten Sektor 1 und in dem zweiten Sektor 2 strömenden Medien (warmes Fluid 101, kaltes Fluid 102) möglich ist.

Wie auch bei der unter Bezugnahme auf die Darstellung in Fig. 1 beschriebenen Ausführungsform der erfindungsgemäßen Lösung ist bei dem in Fig. 2 schematisch dargestellten Wärnictauschersystem 100 eine Fördereinrichtung 5 vorgesehen, deren Saugseite über ein (in Fig. 2 nicht explizit dargestelltes) Leitungs system mit der Zwischenkammer 4 verbunden ist. Die Fördereinrichtung 5 dient dazu, aus der Zwischenkammer 4 Fluid in den ersten Sektor 1 zu fördern. Obwohl in Fig. 2 der Auslass der Fördereinrichtung 5 in der ersten Warmfluidkammer 1-1 mündet, ist es selbstverständlich auch denkbar, dass aus der Zwischenkammer 4 abgeführte Fluid der zweiten Warmfluidkammer 1-2 zuzuführen.

Im Einzelnen ist bei der Fig. 2 dargestellten Ausführungsform vorgesehen, dass die Zwischenkammer 4 über die Rotoröffnung 105 in einen oberen ersten Bereich 4-1 und in einem unteren zweiten Bereich 4-2 eingeteilt wird. Der obere erste Bereicht 4-1 der Zwischenkammer 4 erstreckt sich über einen ersten Bereich 3-1 der ersten Abtrennung 3, und im Einzelnen über den Bereich der ersten Abtrennung 3, welcher die erste Warmfluidkammer 1-1 von der ersten Kaltfluidkammer 2-1 trennt. Der untere zweite Bereich 4-2 der Zwischenkammer 4 erstreckt sich über einen zweiten Bereich 3-2 der ersten Abtrennung 3 und im Einzelnen über den Bereich der ersten Abtrennung 3, welcher die zweite Warmfluidkammer 1-2 von der zweiten Kaltfluidkammer 2-2 trennt. Der zweite Bereich 4-2 der Zwischenkammer 4 steht über entsprechende Kanäle des Rotors 103, mit dem ersten Bereich 4-1 der Zwischenkammer 4 in Fluidverbindung.

Um zu Erreichen, dass mit Hilfe der erfindungsgemäßen Lösung bei dem Wärmetauschersystem 100 gemäß Fig. 2 bzw. Fig. 3 trotz der nicht zu vermeidenden oberen und unteren Spaltöffnungen S1, S2 im Nabenbereich des Rotors 103 beim Betrieb des Wärmetauschersystems 100 kein Fluidübertritt zwischen dem ersten Sektor (erste und zweite Warmfluidkammer 1-1, 1-2) und dem zweiten Sektor 2 (erste und zweite Kaltfluidkammer 2-1, 2-2) auftritt, wird die Fördereinrichtung 5 vorzugsweise über eine geeignete Steuereinrichtung 8 derart angesteuert und die Förderleistung der Fördereinrichtung 5 geregelt, dass in dem ersten Bereich 4-1 der Zwischenkammer 4 ein Unterdruck gegenüber dem in der ersten Warmfluidkammeer 1-1 herrschenden ersten Druck P1-1 erzeugt wird.

Im Einzelnen kann ein Fluidübertritt von der ersten Warmfluidkammer 1-1 zu der benachbarten ersten Kaltfluidkammer 2-1 vollständig verhindert werden, wenn der in dem ersten Bereich 4-1 der Zwischenkammer 4 mit Hilfe der Fördereinrichtung 5 eingestellte Druck P4-1 einen Werte annimmt, der identisch mit dem Wert des in der ersten Kaltfluidkammer 2-1 herrschenden zweiten Druck P2-1 ist. Dann nämlich liegt zwischen dem ersten Bereich 4-1 der Zwischenkammer 4 und der ersten Kaltfluidkammer 2-1 keine Druckdifferenz vor, welche als treibende Kraft für einen Leckagestrom von dem warmen Fluid 101 durch beispielsweise die erste Spaltöffnung S1 wirksam werden kann.

Selbstverständlich kann im Vergleich zu einem Warmetauschersystem 100, bei welchem keinerlei Maßnahmen zur Minderung eines Fluidübertrittes vorgesehen sind, die pro Zeiteinheit von der ersten Warmluftkammer 1-1 zu der ersten Kaltluftkammer 2-1 überströmende Fluidmenge reduziert werden, wenn in dem ersten Bereich 4-1 der Zwischenkammer 4 ein Druck P4-1 erzeugt wird, der kleiner als der in der ersten Warmfluidkammer 1-1 herrschende erste Druck P1-1 und größer als der in der ersten Kaltfluidkammer 2-1 herrschende zweite Druck P2-1 ist.

Andererseits ist es mit der erfindungsgemäßen Lösung auch möglich, einen Fluidübertritt zwischen der zweiten Warmfluidkammer 1-2 und der zweiten Kaltfluidkammer 2-2 wirksam zu verhindern oder zumindest zu reduzieren, obwohl über die zweite Spaltöffnung S2 am Nabenbereich des Rotors 103 eine offene Fluidverbindung zwischen den beiden Fluidkammern 1-2 und 2-2 vorliegt. Da der zweite Bereich 4-2 der Zwischenkammer 4 über Kanäle des Rotors 103 mit dem ersten Bereich 4-1 der Zwischenkammer 4 in Fluidverbindung steht, wird bei Ansteuerung der Fördereinrichtung 5 auch ein Teil des in dem zweiten Bereich 4-2 der Zwischenkammer 4 vorliegenden Fluids in den ersten Sektor (erste Warmfluidkammer 1-1 oder zweite Warmfluidkammer 1-2) gefördert. Auf diese Weise lässt sich mit Hilfe der Fördereinrichtung 5 auch in dem zweiten Bereich 4-2 der Zwischenkammer 4 einen Druck P4-2 einstellen, der kleiner als der in der zweiten Warmfluidkammer 1-2 herrschende dritte Druck P1-2 ist.

Unter der Annahme, dass in der zweiten Warmfluidkammer 1-2 ein dritter Druck P1-2 und in der zweiten Kaltfluidkammer 2-2 ein im Vergleich zum dritten Druck P1-2 niedrigerer vierter Druck P2-2 herrscht, kann eine Reduzierung des Fluidübertrittes zwischen der zweiten Warmfluidkammer 1-2 und der zweiten Kaltfluidkammer 2-2 wirksam erreicht werden, wenn der in dem zweiten Bereich 4-2 der Zwischenkammer 4 erzeugte Druck P4-2 gleich groß wie oder größer als der vierten Druck P2-2 und kleiner als der dritte Druck P1-2 ist.

Wie auch bei der in Fig. 1 dargestellten Ausführungsform findet bei dem in Fig. 2 gezeigten Beispiel eine mit Hilfe der Steuereinrichtung 8 bewirkte automatisch Ansteuerung der Fördereinrichtung 5 statt, um die Förderleistung der Fördereinrichtung 5 in Abhängigkeit von dem in der ersten Kaltfluidkammer 2-1 herrschenden zweiten Druck P2-1, dem in dem ersten Bereich 4-1 der Zwischenkammer 4 erzeugten Druck P4-1, dem in der zweiten Kaltfluidkammer 2-2 herrschenden vierten Druck P2-2 und in Abhängigkeit von dem in dem zweiten Bereich 4-2 der Zwischenkammer 4 erzeugten Druck P4-2 zu bewirken.

Hierfür ist eine Sensoreinrichtung 7 vorgesehen, welche einen ersten Drucksensor 7-1 zum Erfassen des in der ersten Kaltfluidkammer 2-1 herrschenden zweiten Druckes P2-1, einen zweiten Drucksensor 7-2 zum Erfassen des in dem ersten Bereich 4-1 der Zwischenkammer 4 eingestellten Druckes P4-1, einen dritten Drucksensor 7-3 zum Erfassen des in der zweiten halttluidkalllmer 2-2 herrschenden vierten Druckes P2-2 und einen vierten Drucksensor 7-4 zum Erfassen des in dem zweiten Bereich 4-2 der Zwischenkammer 4 herrschenden Druckes P4-2 aufweist.

Die jeweiligen Drucksensoren 7-1 bis 7-4 der Sensoreinrichtung 7 sind ausgelegt, entweder kontinuierlich oder zu vorgegebenen Zeiten bzw. Ereignissen die jeweiligen Druckwerte zu erfassen und diese der Steuereinrichtung 8 zuzuführen, welche die Förderleistung der Fördereinrichtung 5 entsprechend einstellt.

Da die erste Spaltöffnung S1 eine offene Fluidverbindung (unter anderem) zu dem ersten Bereich 4-1 der Zwischenkammer 4 darstellt, strömt über diese offene Fluidverbindung Fluid von der ersten Warmfluidkammer 1-1 zum ersten Bereich 4-1 der Zwischenkammer 4, wenn mit Hilfe der Fördereinrichtung 5 in dem ersten Bereich 4-1 der Zwischenkammer 4 ein Unterdruck gegenüber dem in der ersten Warmfluidkammer 1-1 herrschenden ersten Druck P1-1 erzeugt wird.

Um mit Hilfe der Regelung der Förderleistung der Fördereinrichtung 5 den in dem ersten Bereich 4-1 der Zwischenkammer 4 zu erzeugenden Druck P4-1 geeignet einstellen zu können, um ein Fluidübertritt von der ersten Warmfluidkammer 1-1 zu der ersten Kaltfluidkammer 2-1 wirksam zu verhindern oder zumindest zu reduzieren, ist es erforderlich, die über die erste Spaltöffnung S1 gebildete offene Fluidverbindung bei Bedarf zu variieren. Gleiches gilt auch für die zwischen der zweiten Warmfluidkammer 1-2 und dem zweiten Bereich 4-2 der Zwischenkammer 4 über die zweite Spaltöffnung S2 gebildete offene Fluidverbindung.

Zu diesem Zweck ist bei der in Fig. 2 dargestellten Ausführungsform des WärmetauscherSystems 100 in dem ersten Sektor 1 eine erste Fließbremse 108 vorgesehen, welche ausgelegt ist, ein Überströmen von Fluid aus der ersten Warmfluidkammer 1-1 zu dem ersten Bereich 4-1 der Zwischenkammer 4 über den ersten Spalt S1 sowie ein Überströmen von Fluid aus dem zweiten Bereich 4-2 der Zwischenkammer 4 zu der zweiten Warmfluidkammer 1-2 über den zweiten Spalt S2 zu begrenzen. Im Einzelnen kann die erste Fließbremse 108 ein Abdichtelement in Gestalt eines flexiblen, aufblasbaren Schlauches aufweisen, welcher in einem an der zusätzliche Abtrennung 6 angebrachten U-Profil aufgenommen sein kann. Dieser aufblasbare Schlauch verläuft oberhalb und unterhalb des Rotors 103. Um die pro Zeiteinheit über den ersten Spalt S1 von der ersten Warmfluidkammer 1-1 zu dem ersten Bereich 4-1 der Zwischenkammer 4 überströmende Fluidmenge und die pro Zeiteinheit über den zweiten Spalt S2 von dem zweiten Bereich 4-2 der Zwischenkammer 4 zu der zweiten Warmfluidkammer 1-2 überströmenden Fluidmenge auf einen vorab festgelegten oder festlegbaren Wert einstellen zu können, wird der Schlauch auf einen geregelten Durchmesser aufgeblasen und erzeugt dabei einen verengten aber berührungsfreien Spalt S1, S2 zum Rotor 103.

Grundsätzlich ist es denkbar, dass die erste Fließbremse 108 ausgelegt ist, die pro Zeiteinheit überströmenden Fluidmengen in Abhängigkeit von der Förderleistung der Fördereinrichtung 5 einzustellen. Im Prinzip könnte dabei zumindest ein Teil des mit Hilfe der Fördereinrichtung 5 aus der Zwischenkammer 4 abgeführten Fluids dem flexiblen aufblasbaren Schlauch der ersten Fließbremse 108 zugeführt werden, um ein Aufblasen des Schlauches auf einen geregelten Durchmesser zu bewirken.

Ferner ist eine zweite Fließbremse 109 in dem zweiten Sektor 2 vorgesehen, um ein Überströmen von Fluid aus dem ersten Bereich 4-1 der Zwischenkammer 4 zu der ersten Kaltfluidkammer 2-1 über den ersten Spalt S1 sowie ein Überströmen von Fluid von der zweiten Kaltluftkammer 2-2 zu dem zweiten Bereich 4-2 der Zwischenkammer 4 über den zweiten Spalt S2 zu begrenzen, wenn der in dem ersten Bereich 4-1 der Zwischenkammer 4 eingestellte Druck P4-1 verschieden von dem in der ersten Kaltfluidkammer 2-1 herrschenden zweiten Druck P2-1 und der in dem zweiten Bereich 4-2 der Zwischenkammer 4 eingestellte Druck P4-2 verschieden von dem in der zweiten Kaltfluidkammer 2-2 herrschenden vierten Druck P2-2 ist.

Die zweite Fließbremse 109 kann in gleicher Weise wie die erste Fließbremse 108 als Abdichtelement in Gestalt eines flexiblen aufblasbaren Schlauches ausgebildet sein.

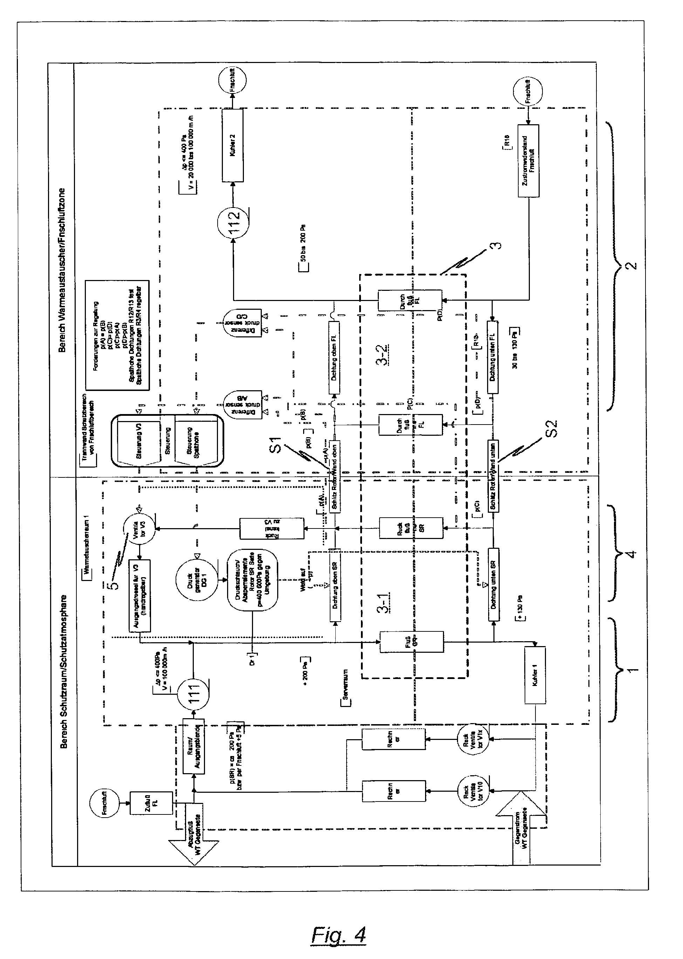

In Fig. 4 sind die bei dem Wärmetauschersystem 100 gemäß Fig. 2 auftretenden Fluidströme schematisch in einer Flussskizze dargestellt, wobei hier der Druck P4-1 in dem ersten Bereich 4-1 der Zwischenkammer 4 identisch mit dem Druck (zweiter Druck P1-2) ist, welcher in der ersten Kaltfluidkammer 2-1 herrscht, und wobei der Druck P4-2 in dem zweiten Bereich 4-2 der Zwischenkammer 4 identisch mit dem Druck (vierter Druck P2-2) ist, welcher in der zweiten Kaltfluidkammer 2-2 herrscht. Wie bereits beschrieben, tritt bei dieser Konstellation kein Fluidübertritt von dem ersten Sektor 1 zu dem zweiten Sektor 2 des Wärmetauschersystems 100 über die erste Abtrennung 3 auf.

Die in Fig. 4 dargestellte Flussskizze behandelt einen speziellen Ausführungsfall, wobei die entsprechenden Parameter der Flussskizze zu entnehmen sind.

Zusammenfassend bleibt festzuhalten, dass die erfindungsgemäße Lösung geeignet ist, bei einem Wärmetauschersvstem 100, bei welchem keine vollständige Dichtigkeit zwischen dem Bereich, in weichem der warme Fluidstrom fließt, und dem Bereich, in welchem der kalte Fluidstrom fließt, möglich ist, eine stoffliche Vermischung des in der Warmzone strömenden ersten Fluids 101 mit dem in der Kaltzone fließenden zweiten Fluid 102 wirksam verhindert werden kann. Demnach ist es denkbar, derartige Wärmetauschersvsteme, die beispielsweise als Wärmeübertrager einen Regenerator aufweisen, auch bei Anwendungen einzusetzen, bei welchen die Atmosphäre eines dauerinertisierten Raumes durch halbdirekte Wärmeübertragung heruntergekühlt werden soll.

Insbesondere eignet sich die erfindungsgemäße Lösung bei der Kühlung eines dauerinertisierten Serverraums 113, in welchem EDV-Einrichtungen 114 permanent unter einer sauerstoffreduzierten Atmosphäre betrieben werden, um dadurch der Brandgefahr zu begegnen. Bei derartigen dauerinertisierten Räume ist es im Hinblick auf die Betriebskosten wesentlich, dass möglichst wenig Inertgas der Raumatmosphäre nachgeführt werden muss, um über längere Zeit ein eingestelltes Inertisierungsniveau zu halten.

Diese Anforderung führte bisher dazu, dass ein herkömmliches Wärmetauschersystem 100, wie es zuvor beispielsweise unter Bezugnahme auf die Darstellung in Fig. 3 beschrieben wurde, nicht wirtschaftlich zur Kühlung der Raumatmosphäre eines dauerinertisierten Raumes eingesetzt werden konnten. Mit der erfindungsgemäßen Lösung kann auf eine einfache aber effektive Art und Weise ein Fluidübertritt zwischen den jeweiligen Zonen des Wärmetauschersystem vollständig verhindert oder zumindest reduziert werden, so dass beim Betrieb des Wärmetauschersystems eine wesentlich geringere Menge der Raumatmosphäre des dauerinertisierten Raumes zu der Kaltluftseite des Wärmetauschersystems strömen kann und somit auch nur eine geringere Menge an Inertgas nachgeführt werden muss.

### Bezugszeichenliste

- 1: erster Sektor
- 1-1: erste Warmfluidkammer
- 1-2: zweite Warmfluidkammer
- 2: zweiter Sektor
- 2-1: erste Kalttluidkaninier
- 2-2: zweite Kaltfluidkammer
- 3: Abtrennung/erste Abtrennung
- 4: Zwischenkammer
- 4-1: erster Bereich der Zwischenkammer
- 4-2: zweiter Bereich der Zwischenkammer
- 5: Fördereinrichtung
- 6: zusätzliche Abtrennung/Seitenwand der Zwischenkammer
- 7: Sensoreinrichtung
- 7-1: erster Drucksensor
- 7-2: zweiter Drucksensor
- 7-3: dritter Drucksensor
- 7-4: vierter Drucksensor
- 8: Steuereinrichtung
- 9: Einrichtung zur Druckentlastung
- 100: Wärmetauschersystem
- 101: warmes Fluid/erstes Fluid
- 102: kaltes Fluid/zweites Fluid
- 103: Wärmeübertrager/Rotor
- 105: Rotoröffnung
- 106: zweite Abtrennung
- 107: dritte Abtrennung
- 108: erste Fließbremse
- 109: zweite Fließbremse
- 111: erster Ventilatorblock
- 112: zweiter Ventilatorblock
- 113: Serverraum
- 114: Edv-Einrichtung

## Patentansprüche

1. Wärmetauschersystem (100) zum Übertragen von Wärmeenergie zwischen einem warmen Fluid (101) und einem kalten Fluid (102), wobei das Wärmetauschersystem (100) folgendes aufweist:
- einen ersten Sektor (1, 1-1), der von dem warmen Fluid (101) durchströmt wird, und einen zweiten Sektor (2, 2-1), der von dem kalten Fluid (102) durchströmt wird;
- eine erste Abtrennung (3), welche den ersten Sektor (1) und den zweiten Sektor (2) räumlich voneinander trennt, wobei über zumindest einen ersten Bereich (3-1) der ersten Abtrennung (3) in dem ersten Sektor (1, 1-1) ein erster Druck (P1-1) und in dem zweiten Sektor (2, 2-1) ein im Vergleich zum ersten Druck (P1-1) niedrigerer zweiter Druck (P2-1) herrscht;
- einen Wärmeübertrager in Gestalt eines Regenerators zum Übertragen von thermischer Energie von dem warmen Fluidstrom zu dem kalten Fluidstrom; und
- mindestens eine Vorrichtung zum Minimieren eines ungewollten Fluidübertritts von dem ersten Sektor (1,1-1) zu dem zweiten Sektor (2, 2-1) über den ersten Bereich (3-1) der ersten Abtrennung (3), wobei die Vorrichtung an der ersten Abtrennung (3) eine Zwischenkammer (4) aufweist, welche die beiden Sektoren (1, 1-1, 2, 2-1) voneinander trennt, und wobei die Vorrichtung ferner eine Fördereinrichtung (5) aufweist, welche ausgelegt ist, Fluid von der Zwischenkammer (4) in den ersten Sektor (1, 1-1) zu fördern, um in der Zwischenkammer (4) einen Unterdruck gegenüber dem im ersten Sektor (1, 1-1) herrschenden ersten Druck (P1-1) zu erzeugen, wobei der in der Zwischenkammer (4) erzeugte Druck (P4-1) gleich groß wie oder größer als der im zweiten Sektor (2, 2-1) herrschende zweite Druck (P2-1) ist.

2. Wärmetauschersystem (100) nach Anspruch 1,
wobei die Seitenwände der Zwischenkammer (4) durch die erste Abtrennung (3) einerseits und durch eine von der ersten Abtrennung (3) in Richtung des ersten Sektors (1,1-1) beabstandete zusätzliche Abtrennung (6) andererseits gebildet werden;
wobei über einen ersten Bereich (3-1) der ersten Abtrennung (3) in dem ersten Sektor (1, 1-1) ein erster Druck (P1-1) und in dem zweiten Sektor (2, 2-1) ein im Vergleich zum ersten Druck (P1-1) niedrigerer zweiter Druck (P2-1) herrscht, und wobei über einen zweiten Bereich (3-2) der ersten Abtrennung (3) in dem ersten Sektor (1, 1-2) ein dritter Druck (P1-2) und in dem zweiten Sektor (2, 2-2) ein im Vergleich zum dritten Druck (P1-2) niedrigerer vierter Druck (P2-2) herrscht; wobei die Zwischenkammer (4) einen ersten Bereich (4-1) aufweist, der sich über den ersten Bereich (3-1) der ersten Abtrennung (3) erstreckt, und einen zweiten Bereich (4-2) aufweist, der sich über den zweiten Bereich (3-2) der ersten Abtrennung (3) erstreckt und in Fluidverbindung mit dem ersten Bereich (4-1) der Zwischenkammer (4) steht,
wobei die Fördereinrichtung (5) ausgelegt ist, in dem ersten Bereich (4-1) der Zwischenkammer (4) einen Unterdruck gegenüber dem ersten Druck (P1-1) zu erzeugen und in dem zweiten Bereich (4-2) der Zwischenkammer (4) einen Überdruck gegenüber dem dritten Druck (P1-2) zu erzeugen, wobei der in dem ersten Bereich (4-1) der Zwischenkammer (4) erzeugte Druck (P4-1) gleich groß wie oder größer als der zweite Druck (P2-1) ist, und wobei der in dem zweiten Bereich (4-2) der Zwischenkammer (4) erzeugte Druck (P4-2) gleich groß wie oder größer als der vierte Druck (P2-2) ist.

3. Wärmetauschersystem (100) nach Anspruch 2,
wobei der Wärmeübertrager einen drehbar gelagerten Rotor (103) umfasst, welcher zur Drehachse parallele Kanäle aufweist und sich derart durch eine durch die erste Abtrennung (3) und die zusätzliche Abtrennung (6) laufende Rotoröffnung (105) erstreckt, dass er bei einer Drehung den ersten und zweiten Sektor (1, 2) durchläuft, und wobei ferner folgendes vorgesehen ist:
- eine zweite Abtrennung (106), welche in dem ersten Sektor (1) derart angeordnet ist, dass der erste Sektor (1) in eine erste Warmfluidkammer (1-1) und in eine zweite Warmfluidkammer (1-2) eingeteilt wird, welche über sich im ersten Sektor (1) befindenden Kanälen des Rotors (103) in Fluidverbindung stehen;
- eine dritte Abtrennung (107), welche in dem zweiten Sektor (2) derart angeordnet ist, dass der zweite Sektor (2) in eine erste Kaltfluidkammer (2-1) und in eine zweite Kaltfluidkammer (2-2) eingeteilt wird, welche über sich im zweiten Sektor (2) befindenden Kanälen des Rotors (103) in Fluidverbindung stehen,
wobei ein Fluidübertritt durch die erste Abtrennung (3) von einem der Sektoren (1, 2) zu dem anderen der Sektoren (2, 1) minimiert wird, indem die jeweils über die erste Abtrennung (3) anfallende Druckdifferenz zwischen einer Kaltfluidkammer (2-1, 2-2) und der dazu benachbarten Warmfluidkammer (1-1, 1-2) minimiert wird.

4. Wärmetauschersystem (100) nach Anspruch 3,
wobei der erste Bereich (4-1) der Zwischenkammer (4) mit dem zweiten Bereich (4-2) der Zwischenkammer (4) über sich im ersten Sektor (1) befindenden Kanälen des Rotors (103) in Fluidverbindung stehen.

5. Wärmetauschersystem (100) nach Anspruch 3 oder 4, welches ferner folgendes aufweist:
- eine Sensoreinrichtung (7) mit einem ersten Drucksensor (7-1) zum Erfassen des in der ersten Kaltfluidkammer (2-1) herrschenden zweiten Druckes (P2-1), einem zweiten Drucksensor (7-2) zum Erfassen des im ersten Bereich (4-1) der Zwischenkammer (4) eingestellten Druckes (P4-1), einem dritten Drucksensor (7-3) zum Erfassen des in der zweiten Kaltfluidkammer (2-2) herrschenden vierten Druckes (P2-2) und mit einem vierten Drucksensor (7-4) zum Erfassen des in dem zweiten Bereich (4-2) der Zwischenkammer (4) herrschenden Druckes (P4-2); und
- eine Steuereinrichtung (8) zum Steuern der Förderleistung der Fördereinrichtung (5),
wobei die Steuereinrichtung (8) ausgelegt ist, vorzugsweise automatisch die Fördereinrichtung (5) derart anzusteuern, dass die Differenz zwischen dem erfassten Wert des zweiten Druckes (P2-1) und dem erfassten Wert des im ersten Bereich (4-1) der Zwischenkammer (4) erzeugten Druckes (P4-1) einen vorab festegelegten oder festlegbaren Wert annimmt, und dass die Differenz zwischen dem erfassten Wert des vierten Druckes (P2-2) und dem erfassten Wert des in dem zweiten Bereich (4-2) der Zwischenkammer (4) erzeugten Druckes (P4-2) einen vorab festgelegten oder festlegbaren Wert annimmt.

6. Wärmetauschersystem (100) nach einem der Ansprüche 3 bis 5,
wobei im ersten Sektor (1) ferner eine erste Fließbremse (108) vorgesehen ist, welche ausgelegt ist, ein Überströmen von Fluid aus der ersten Warmfluidkammer (1-1) zu dem ersten Bereich (4-1) der Zwischenkammer (4) über einen ersten Spalt (S1) zwischen dem Rotor (103) und der zusätzlichen Abtrennung (6) bei der Rotoröffnung (105) sowie ein Überströmen von Fluid aus dem zweiten Bereich (4-2) der Zwischenkammer (4) zu der zweiten Warmfluidkammer (1-2) über einen zweiten Spalt (S2) zwischen dem Rotor (103) und der zusätzlichen Abtrennung (6) bei der Rotoröffnung (105) zu begrenzen.

7. Wärmetauschersystem (100) nach Anspruch 6,
wobei die erste Fließbremse (108) derart ansteuerbar ist, dass die pro Zeiteinheit über den ersten Spalt (S1) von der ersten Warmfluidkammer (1-1) zu dem ersten Bereich (4-1) der Zwischenkammer (4) überströmende Fluidmenge und die pro Zeiteinheit über den zweiten Spalt (S2) von dem zweiten Bereich (4-2) der Zwischenkammer (4) zu der zweiten Warmfluidkammer (1-2) überströmende Fluidmenge auf einen vorab festgelegten oder festlegbaren Wert einstellbar sind.

8. Wärmetauschersystem (100) nach Anspruch 7,
wobei die erste Fließbremse (108) ausgelegt ist, die pro Zeiteinheit überströmenden Fluidmengen in Abhängigkeit von der Förderleistung der Fördereinrichtung (5) einzustellen.

9. Wärmetauschersystem nach einem der Ansprüche 3 bis 8,
wobei im zweiten Sektor (2) eine zweite Fließbremse (109) vorgesehen ist, um ein Überströmen von Fluid aus dem ersten Bereich (4-1) der Zwischenkammer (4) zu der ersten Kaltfluidkammer (2-1) über den ersten Spalt (S1) zwischen dem Rotor (103) und der ersten Abtrennung (3) bei der Rotoröffnung (105) sowie ein Überströmen von Fluid von der zweiten Kaltluftkammer (2-2) zu dem zweiten Bereich (4-2) der Zwischenkammer (4) über den zweiten Spalt (S2) zwischen dem Rotor (103) und der ersten Abtrennung (3) bei der Rotoröffnung (105) zu begrenzen.

10. Wärmetauschersystem nach einem der Ansprüche 6 bis 9,
wobei die Fließbremse (108, 109) ein Abdichtelement in Gestalt eines flexiblen aufblasbaren Schlauches aufweist, welcher an der zusätzlichen Abtrennung (6) an den beiden Spalten (S1, S2) zwischen der zusätzlichen Abtrennung (6) und dem Rotor (103) angeordnet ist.

## Claims

1. A heat transfer system (100) for transferring thermal energy between a hot fluid (101) and a cold fluid (102), whereby the heat transfer system (100) includes the following:
- a first sector (1, 1-1) through which the hot fluid (101) flows, and a second sector (2, 2-1) through which cold fluid flows;
- a first partition (3) that separates the first sector (1) and the second sector (2) spatially, whereby in an at least first section (3-1) of the first partition (3) in the first sector (1, 1-1), a first pressure (P1-1) prevails and in the second sector (2, 2-1), a second pressure (P2-1) prevails that is lower compared to the first pressure (P1-1);
- a heat exchanger in the form of a regenerator for transferring thermal energy from the hot fluid flow to the cold fluid flow; and
- at least one device for minimizing any unintentional amount of fluid passing from the first sector (1, 1-1) to the second sector (2, 2-1) through the first section (3-1) of the first partition (3), whereby the device has an intermediate chamber (4) at the first partition (3), which partitions the two sectors (1, 1-1, 2, 2-1), and whereby the device further has a transport system (5) which is configured to transport fluid from the first intermediate chamber (4) into the first sector (1, 1-1), in order to generate an underpressure in intermediate chamber (4) with respect to pressure (P1-1) that prevails in the first sector (1, 1-1), whereby the pressure (P4-1) generated in the intermediate chamber is equal to or larger than the second pressure (P2-1) that prevails in the second sector (2, 2-1).

2. A heat transfer system (100) as recited in Claim 1,
whereby the lateral walls of the intermediate chamber (4) are formed for one, by the first partition (3), and for another, by an additional partition (6) at a distance from the first partition (3) in the direction of the first sector (1,1-1);
whereby in a first section (3-1) of the first partition (3) in the first sector (1, 1-1), a first pressure (P1-1) prevails, and in the second sector (2, 2-1), a second pressure (P2-1) prevails that is lower compared to the first pressure (P1-1), and whereby in a second section (3-2) of the first partition (3), a third pressure (P1-2) prevails in the first sector (1, 1-2), and in the second sector (2, 2-2), a lower fourth pressure (P2-2) prevails compared to the third pressure (P1-2);
whereby the intermediate chamber (4) has a first section (4-1), that extends along the first section (3-1) of the first partition (3), and a second section (4-2), that extends over the second section (3-2) of the first partition (3), and has a fluid connection with the first section (4-1) of intermediate chamber (4),
whereby the transport system (5) is configured to generate an underpressure with respect to the first pressure (P1-1) in the intermediate chamber (4), and in the second section (4-2) of the intermediate chamber (4) an overpressure with respect to the third pressure (P1-2), whereby the pressure (P4-1) generated in the first section 4-1) of intermediate chamber (4) is equal to or larger than the second pressure (P2-1), and whereby the pressure (P4-2) generated in the second section (4-2) of intermediate chamber (4) is equal to or larger than the fourth pressure (P2-2).

3. A heat transfer system (100) as recited in Claim 2,
whereby the heat exchanger includes a rotor (103) that is mounted rotatable, which has channels that are parallel to the axis of rotation and which extends in such a way through the rotor opening (105) that extends through the first partition (3) and the additional partition (6), that upon a rotation, it passes through the first and the second sector (1, 2), and whereby further, the following is provided:
- a second partition (106), which is located in the first sector (1) in such a way that the first sector (1) is divided into a first hot fluid chamber (1-1) and into a second hot fluid chamber (1-2), which has a fluid connection through the channels of rotor (103) in the first sector (1);
- a third partition (107), which is located in the second sector (2) in such a way that the second sector (2) is partitioned into a first cold fluid chamber (2-1) and into a second cold fluid chamber (2-2), which have a fluid connection through the channels of the rotor (103) that are located in the second sector (2),
whereby a fluid transfer through the first partition (3) from one of the sectors (1, 2) to the other sectors (2, 1) is minimized by minimizing the respectively occurring pressure difference at the first partition (3) between a cold fluid chamber (2-1, 2-2) and the hot fluid chamber (1-1, 1-2) adjacent to it.

4. A heat transfer system (100) as recited in Claim 3,
whereby the first section (4-1) of the intermediate chamber (4) has a fluid connection with the second section (4-2) of the intermediate chamber (4) by using the channels of rotor (103) that are located in sector (1).

5. A heat transfer system (100) as recited in Claim 3 or 4, which further includes the following:
- a sensor unit (7) with a first pressure sensor (7-1) for detecting the second pressure (P2-1) prevailing in the first cold fluid chamber (2-1), a second pressure sensor (7-2) for detecting the pressure (P4-1) that is selected in the first section (4-1) of the intermediate chamber (4), a third pressure sensor (7-3) for detecting the fourth pressure (P2-2) prevailing in the second cold fluid chamber (2-2), and a fourth pressure sensor (7-4) for detecting the pressure (P4-2) prevailing in the second section (4-2) of the intermediate chamber (4); and
- a control unit (8) for controlling the volume pressure of the transport system (5), whereby the control unit (8) is configured to preferably control the transport system (5) automatically in such a way that the difference between the detected value of the second pressure (P2-1) and the detected value of pressure (P4-1) generated in the first section (4-1) of the intermediate chamber (4), takes on a predetermined or specifiable value, and that the difference between the detected value of the fourth pressure (P2-2) and the detected value of pressure (P4-2) that is generated in the second section (4-2) of the intermediate chamber (4) takes on a predetermined or specifiable value.

6. A heat transfer system (100) as recited in one of Claims 3 through 5,
whereby in the first sector (1), furthermore, a first flow brake (108) is provided, which is configured to limit an overflowing of fluid out of the first hot fluid chamber (1-1) into the first section (4-1) of the intermediate chamber (4) through a gap (S1) between the rotor (103) and the additional partition (6) at the rotor opening (105), as well as an overflowing of fluid from the second section (4-2) of intermediate chamber (4) to the second hot fluid chamber (1-2) through a second gap (S2) between the rotor (103) and the additional partition (6) at the rotor opening (105).

7. A heat transfer system (100) as recited in Claim 6,
whereby the first flow brake (108) can be controlled in such a way that the overflowing amount of fluid through the first gap (S1) from the first hot fluid chamber (1-1) into the first section (4-1) of the intermediate chamber (4) can be adjusted per unit of time, and the amount of overflowing fluid per unit of time through the second gap (S2) from the second section (4-2) of the intermediate chamber (4) into the second hot fluid chamber (1-2), can be adjusted to a predetermined or specifiable value.

8. A heat transfer system (100) as recited in Claim 7,
whereby the first flow brake (108) is configured to adjust the overflowing amounts of fluid depending on the flow rate of the transport system (5).

9. A heat transfer system as recited in one of Claims 3 through 8,
whereby in the second sector (2) a second flow brake (109) is provided to limit an overflowing of fluid from the first section (4-1) of the intermediate chamber (4) into the first cold fluid chamber (2-1) through a first gap (51) between the rotor (103) and the first partition (3) at the rotor opening (105), as well as an overflowing of fluid from the second cold air chamber (2-2) to the second section (4-2) of the intermediate chamber (4) through a second gap (S2) between the rotor (103) and the first partition (3) at rotor opening (105).

10. A heat transfer system as recited in one of Claims 6 through 9,
whereby the flow brake (108, 109) is a sealing element in the form of a flexible, inflatable hose, which is located at the additional partition (6) at both gaps (S1, S2) between the additional partition (6) and the rotor (103).

## Revendications

1. Système d'échange thermique (100) pour le transfert d'énergie thermique entre un fluide chaud (101) et un fluide froid (102), le système d'échange thermique (100) comprenant ce qui suit :
- un premier secteur (1, 1-1), qui est parcouru par le fluide chaud (101), et un deuxième secteur (2, 2-1), qui est parcouru par le fluide froid (102) ;
- une première cloison de séparation (3) qui sépare spatialement l'un de l'autre le premier secteur (1) et le deuxième secteur (2), une première pression (P1-1) régnant dans le premier secteur (1, 1-1) et une deuxième pression (P2-1), inférieure à la première pression (P1-1), régnant dans le deuxième secteur (2, 2-1) au niveau d'au moins une première partie (3-1) de la première cloison de séparation (3) ;
- un échangeur thermique prenant la forme d'un régénérateur, destiné à transférer de l'énergie thermique entre le flux de fluide chaud et le flux de fluide froid ; et
- au moins un dispositif destiné à rendre minimal un passage non voulu de fluide entre le premier secteur (1, 1-1) et le deuxième secteur (2, 2-1) au niveau de la première partie (3-1) de la première cloison de séparation (3), le dispositif placé sur la première cloison de séparation (3) comprenant une chambre intermédiaire (4) qui sépare les deux secteurs (1, 1-1, 2, 2-1) l'un de l'autre et le dispositif comprenant en outre un dispositif de circulation (5) qui est conçu pour refouler du fluide de la chambre intermédiaire (4) dans le premier secteur (1, 1-1) afin de produire dans la chambre intermédiaire (4) une dépression par rapport à la première pression (P1-1) régnant dans le premier secteur (1, 1-1), la pression (P4-1) produite dans la chambre intermédiaire (4) étant égale ou supérieure à la deuxième pression (P2-1) régnant dans le deuxième secteur (2, 2-1).

2. Système d'échange thermique (100) selon la revendication 1,
dans lequel les parois latérales de la chambre intermédiaire (4) sont formées, d'une part, par la première cloison de séparation (3) et, d'autre part, par une nouvelle cloison de séparation (6) écartée de la première cloison de séparation (3) dans la direction du premier secteur (1, 1-1) ;
dans lequel il règne dans le premier secteur (1, 1-1) une première pression (P1-1) et dans le deuxième secteur (2, 2-1) une deuxième pression (P2-1), inférieure à la première pression (P1-1), au niveau d'une première partie (3-1) de la première cloison de séparation (3) ; et
dans lequel il règne dans le premier secteur (1, 1-2) une troisième pression (P1-2) et dans le deuxième secteur (2, 2-2) une quatrième pression (P2-2) inférieure à la troisième pression (P1-2), au niveau d'une deuxième partie (3-2) de la première cloison de séparation (3) ;
dans lequel la chambre intermédiaire (4) possède une première partie (4-1) qui s'étend sur la première partie (3-1) de la première cloison de séparation (3) et une deuxième partie (4-2) qui s'étend sur la deuxième partie (3-2) de la première cloison de séparation (3) et qui est en communication fluidique avec la première partie (4-1) de la chambre intermédiaire (4) ;
dans lequel le dispositif de circulation (5) est conçu pour produire dans la première partie (4-1) de la chambre intermédiaire (4) une dépression par rapport à la première pression (P1-1) et dans la deuxième partie (4-2) de la chambre intermédiaire (4) une surpression par rapport à la troisième pression (P1-2), la pression (P4-1) produite dans la première partie (4-1) de la chambre intermédiaire (4) étant égale ou supérieure à la deuxième pression (P2-1) et la pression (P4-2) produite dans la deuxième partie (4-2) de la chambre intermédiaire (4) étant égale ou supérieure à la quatrième pression (P2-2).

3. Système d'échange thermique (100) selon la revendication 2,
dans lequel l'échangeur thermique comprend un rotor (103) monté rotatif qui possède des canaux parallèles à l'axe de rotation et qui s'étend dans une ouverture de rotor (105) délimitée par la première cloison de séparation (3) et la nouvelle cloison de séparation (6), si bien qu'il parcourt dans une rotation le premier et le deuxième secteur (1, 2) ; et
dans lequel il est en outre prévu :
- une deuxième cloison de séparation (106) qui est implantée dans le premier secteur (1) de manière que le premier secteur (1) soit subdivisé en une première chambre de fluide chaud (1-1) et une deuxième chambre de fluide chaud (1-2) qui se trouvent en communication fluidique par l'intermédiaire des canaux du rotor (103) qui se situent dans le premier secteur (1) ;
- une troisième cloison de séparation (107) qui est implantée dans le deuxième secteur (2) de manière que le deuxième secteur (2) soit subdivisé en une première chambre de fluide froid (2-1) et une deuxième chambre de fluide froid (2-2) qui se trouvent en communication fluidique par l'intermédiaire des canaux du rotor (103) qui se situent dans le deuxième secteur (2) ;
dans lequel est rendu minimal un passage de fluide au travers de la première cloison de séparation (3) entre l'un des secteurs (1, 2) et l'autre secteur (2, 1) en rendant minimale la différence de pression respective présente au niveau de la première cloison de séparation (3) entre l'une des chambres de fluide froid (2-1, 2-2) et la chambre de fluide chaud (1-1, 1-2) adjacente.

4. Système d'échange thermique (100) selon la revendication 3,
dans lequel la première partie (4-1) de la chambre intermédiaire (4) est en communication fluidique avec la deuxième partie (4-2) de la chambre intermédiaire (4) par l'intermédiaire des canaux du rotor (103) qui se situent dans le premier secteur (1).

5. Système d'échange thermique (100) selon l'une des revendications 3 ou 4, comprenant en outre :
- un dispositif de détection (7) comportant un premier capteur de pression (7-1), destiné à détecter la deuxième pression (P2-1) régnant dans la première chambre de fluide froid (2-1), un deuxième capteur de pression (7-2), destiné à détecter la pression (P4-1) réglée dans la première partie (4-1) de la chambre intermédiaire (4), un troisième capteur de pression (7-3), destiné à détecter la quatrième pression (P2-2) régnant dans la deuxième chambre de fluide froid (2-2), et un quatrième capteur de pression (7-4), destiné à détecter la pression (P4-2) régnant dans la deuxième partie (4-2) de la chambre intermédiaire (4) ; et
- un dispositif de commande (8), destiné à commander la puissance de circulation du dispositif de circulation (5) ;
dans lequel le dispositif de commande (8) est conçu pour piloter le dispositif de circulation (5), de préférence automatiquement, de manière que la différence entre la valeur détectée de la deuxième pression (P2-1) et la valeur détectée de la pression produite (P4-1) dans la première partie (4-1) de la chambre intermédiaire (4) prenne une valeur prédéterminée ou prédéterminable, et que la différence entre la valeur détectée de la quatrième pression (P2-2) et la valeur détectée de la pression (P4-2) produite dans la deuxième partie (4-2) de la chambre intermédiaire (4) prenne une valeur prédéterminée ou prédéterminable.

6. Système d'échange thermique (100) selon l'une des revendications 3 à 5,
dans lequel il est prévu en outre dans le premier secteur (1) une première restriction à l'écoulement (108) qui est conçue pour limiter un échappement de fluide entre la première chambre de fluide chaud (1-1) et la première partie (4-1) de la chambre intermédiaire (4) par une première fente (S1) entre le rotor (103) et la nouvelle cloison de séparation (6) au niveau de l'ouverture de rotor (105) ainsi qu'un écoulement de fluide entre la deuxième partie (4-2) de la chambre intermédiaire (4) et la deuxième chambre de fluide chaud (1-2) par une deuxième fente (S2) entre le rotor (103) et la nouvelle cloison de séparation (6) au niveau de l'ouverture de rotor (105).

7. Système d'échange thermique (100) selon la revendication 6,
dans lequel la première restriction à l'écoulement (108) est apte à être commandée de manière à pouvoir régler à une valeur prédéterminée ou prédéterminable la quantité de fluide s'échappant par unité de temps par la première fente (S1) entre la première chambre de fluide chaud (1-1) et la première partie (4-1) de la chambre intermédiaire (4) et la quantité de fluide s'échappant par unité de temps par la deuxième fente (S2) entre la deuxième partie (4-2) de la chambre intermédiaire (4) et la deuxième chambre de fluide chaud (1-2).

8. Système d'échange thermique (100) selon la revendication 7,
dans lequel la première restriction à l'écoulement (108) est conçue pour régler les quantités de fluide s'échappant par unité de temps en fonction de la capacité de circulation du dispositif de circulation (5).

9. Système d'échange thermique (100) l'une des revendications 3 à 8,
dans lequel il est prévu une deuxième restriction à l'écoulement (109) dans le deuxième secteur (2) afin de limiter un échappement de fluide entre la première partie (4-1) de la chambre intermédiaire (4) et la première chambre de fluide froid (2-1) par la première fente (S1) entre le rotor (103) et la première cloison de séparation (3) au niveau de l'ouverture de rotor (105) ainsi qu'un échappement de fluide entre la deuxième chambre de fluide froid (2-2) et la deuxième partie (4-2) de la chambre intermédiaire (4) par la deuxième fente (S2) entre le rotor (103) et la première cloison de séparation (3) au niveau de l'ouverture de rotor (105).

10. Système d'échange thermique (100) selon l'une des revendications 6 à 9,
dans lequel la restriction à l'écoulement (108, 109) possède un élément d'étanchéité sous la forme d'un boyau flexible pouvant être gonflé, fixé sur la nouvelle cloison de séparation (6), au niveau des deux fentes (S1, S2) entre la nouvelle cloison de séparation (6) et le rotor (103).
